# EUROPEAN PATENT APPLICATION

(11) **EP 2 479 594 A1**
(43) Date of publication of application: **25.07.2012**
(21) Application number: 11000494.2
(22) Date of filing: 21.01.2011
(51) Int. Cl.: G02B 6/38, G02B 6/42, H01S 5/00

(54) **Robust pigtail system for high power laser modules**

(71) Applicant: Oclaro Technology Limited, Caswell Towcester Northamptonshire NN12 8EQ (GB)
(72) Inventor: Brunner, Reinhard, 8905 Ami (CH); Lützelschwab, Markus, 6005 Luzern (CH); Valk, Bernhard, 8918 Unterlunkhofen (CH); Pierer, Jörg, 6375 Beckenried (CH)
(74) Representative: Barth, Carl Otto

(57) **Abstract**

In a high power, i.e. 100W and more, semiconductor laser module, used e.g. in opto-electronics as pump laser modules or in laser machining or medical applications, the laser power is launched into a glass fiber which transports the optical power to a desired location. It is difficult to focus the full laser power into the fiber core's end (8). Any misalignment results in stray energy heating up the fiber and its cladding, often resulting in catastrophic failure of the affected module. The invention concerns a robust and cost-effective design to manage and dissipate the heat generated by absorbing uncontrolled uncoupled and de-coupled stray light or radiation by providing a structure of a transparent ferrule (6) holding the fiber core (2) with its cladding (12), this ferrule (6) being fixed to a heat-dissipating component of the module by a transparent adhesive (20), whereby core (2), cladding (12), adhesive (20), and ferrule (6) each have a predetermined refractive index, chosen such that stray radiation is directed into the heat-dissipating component (5). A reflector (13) at the inner end of the ferrule (6), i.e. opposite the laser and preferably funnel-shaped, diverts any remaining stray radiation also towards the heat-dissipating component (5). This combination of features minimizes or avoids catastrophic damage such as melt-down or ignition.

## Description

### Field of the Invention

The invention relates to high power solid-state diode laser modules in which the laser power is bundled or launched into a coated optical glass fiber which serves to transport the optical energy to a desired location. One of this type of modulesis commonly used in opto-electronics as a so-called pump laser for a fiber amplifier in optical communications, e.g. for an erbium-doped fiber amplifier (EDFA) or a Raman amplifier. Other types are used for laser machining or medical applications. Such laser modules now often launch an optical energy of 100W and more into the optical fiber. Usually, the fiber includes a core, a cladding, and a covering or tubing as mechanical protection. The fiber connection system, the so-called pigtail, generally includes a ferrule, often of a glass material, which ferrule clasps around the fiber. This ferrule holds the fiber mechanically and usually extends up to the front end of the fiber opposite the laser. The danger of catastrophic failure of such modules, i.e. burning out of the fiber interface or entry, increases dramatically when the optical focus of the laser is or becomes misaligned with the fiber entry. The invention concerns a robust and cost-effective design and system for controlling the heat dissipation at the fiber pigtail, thus minimizing or avoiding catastrophic failures such as melt-down or ignition.

### Background and Prior Art

Semiconductor laser modules of the type of concern have, for example, become important components in the technology of communication in optical fiber networks because such lasers can be used for amplifying optical signals directly by optical means. This permits the design of all-optical fiber communication systems, thus avoiding complicated optical/electrical conversion of the signals to be transmitted which thus improves speed as well as reliability within such systems.

Another application of laser modules of the type of concern here is in the medical field, in particular where laser power has to be conducted to a specific area of a human or animal body. In such applications, reliability and precision plays an important role.

A third application is in the area of machining and processing of materials, e.g. cutting, welding, ablation, annealing, engraving, sintering, printing, scribing, marking, drilling and/or patterning. These are applications in which manufacturers and processors in the semiconductor, electronics, automotive, medical, food and packing industry sectors are interested.

In respect of the nomenclature used in the following: "fiber" means the complete assembly consisting of the core, the cladding and the covering or tubing; "core" denotes the inner radiation-guiding glass fiber; "cladding" stands for the layer surrounding the core, usually with a lower index of refraction than the core to keep the radiation in the core; "covering" means the outside protective tubing that safeguards the fiber.

Some types of fibers feature dual claddings with a core surrounded by a first, lower index cladding which is then surrounded by a second, even lower index cladding to enhance the removal of cladding light from the fiber.

Recent developments have led to more and more powerful lasers and laser devices, including optical fiber devices and modules of the type of concern here. The power increase unfortunately also increases the danger of overheating with the resulting hazard of catastrophic failure and even fire.

Today, fiber-coupled high power laser diodes are commercially available with wavelengths ranging from 300nm to 3000nm and optical output powers from a few mW to 130W out of the fiber.

Especially for high output powers, the focusing of the laser output, the alignment of the fiber entry, and the dissipation of stray radiation, i.e. radiation that does not enter the fiber core, are extremely important factors which determine reliability and lifetime of fiber-coupled laser modules. A significant optical and mechanical part of such fiber-coupled lasers is the optical connection between the laser and the fiber. So-called fiber pigtails have proven to be a good solution for this problematic connection. They usually include a rigid sleeve or tube engirding the fiber and serving as mechanical holder for the fiber in a housing which comprises the radiation-producing laser or lasers.

There are various reasons why the "light-fiber interface", i.e. the area where the laser radiation or "light" (which in fact might be invisible) is focused onto the face of an optical fiber, is a particularly problematic zone in any such laser module.

Firstly, the fiber core, i.e. the light-transporting part of the fiber, into which the laser light has to be transmitted, often has a rather small diameter, just 8-9µm typically for single-mode fibers. In a multi-mode fiber, the core diameter fiber may be 50-100µm, i.e. 0.1 mm. About the same diameter have so-called gradient-index fibers, where the core is not defined by a sharp, but a gradual difference, of the index of reflection between the center of the fiber and the cladding.

Though the problem decreases with growing fiber diameters - there are mult-mode fibers of 400µm and more - it still exists.

It is challenging to focus a beam parameter product (BPP, defined below) generated by a single laser or a plurality of single emitter lasers with a combined power of 100W and more on to a small spot size since the beam must be well coupled into the fiber during operation at different thermal loads. The beam parameter product (BPP) is the product of a laser beam's divergence angle and the radius of the beam at its narrowest point. The BPP quantifies the quality of a laser beam and how well it can be focused to a small spot. The BPP of two or more combined beams or emitters is always worse than the beam parameter product of one single beam or emitter.

A typical laser module with a plurality of single emitter lasers, as mentioned above, is disclosed in the published patent application WO 2001/089638 A2 by Bernd Valk and assigned to the assignee of the present application.

Secondly, the fiber usually consists of the above-mentioned, dielectric core having a first index of refraction, covered by a cladding of some µm thickness with a somewhat lower index of refraction, and a further coating, covering, or tubing, often an acrylate, to mechanically protect the fiber. In particular the latter is rather heat sensitive, having a flashpoint of less than 200 °C. A misaligned light spot with the energy density described above or other stray radiation of sufficient power can thus easily damage, even melt or ignite the acrylate coating of the fiber, resulting in a quick catastrophic failure of the whole device.

The main objective of the present invention is to avoid such local overheating at the laser pigtail by leading any stray light away from the fiber - except the core, of course - and thus keep the fiber and especially its components at acceptable temperatures.

The European Patent EP 151 909 B1 discloses a first approach. To avoid the absorbed power density in the sensitive coverings of a fiber becoming too high, the coverings are replaced by a layer of radiation-resistant, transmitting material at the entrance side of the fiber. The replacement material has a refractive index exceeding or approximately equal to the refractive index of the cladding, so that radiation leaking and entering the cladding and propagating in it is coupled out into the radiation-resistant layer. Additional layers enclosing the resistant layer provide for heat conduction and radiation absorption.

The US published patent application US2006/0171631 A1 shows a second approach. A fiber stub including an optical fiber with its cladding is surrounded by a glass ferrule. The ferrule has a refractive index that is greater than the refractive index of the fiber. As a result, stray radiation is refracted into the ferrule, away from the fiber core. An absorptive layer on the surface of the ferrule may absorb the refracted radiation.

A third approach is disclosed in the report by Ola Blomster et al., Optoskand AB, SE-431 37 Mölndal, Sweden, "Small fiber connector for high-power transmission", presented at the World of Photonics Congress in Munich, Germany, in June 2009. It describes a fiber connector in which the stray radiation is led away from the fiber and absorbed in the housing instead.

The US published patent application US20090251697/0171631 A1 discloses a further approach. It shows a high power, multi-emitter laser module with a pigtail, but focuses on the heat removal from the lasers and only mentions the removal of heat from the fiber.

The above-described approaches provide some dissipation of stray radiation or heat in the entrance region of the fiber, but have in common that they do not guarantee that all stray radiation is removed before it can enter parts of the fiber except the core, in particular the outer coating. The latter, as explained above, is often the part most at risk in the optical interface region of a fiber system. To provide a reliable light-to-fiber interface for high power radiation, stray light must be kept as far as possible away from the fiber coatings to avoid heating up of the latter.

A further solution is shown in the WO 94/06045 by D.M. Filgas et al. in an optical fiber connection system. An individual reflector component between a ferrule facing the laser and a fiber attachment tube reflects scattered laser radiation into a heat conducting holder. Though this approach seems to provide a better solution to the "stray radiation problem", it has the disadvantage to require an additional component, i.e. the reflector, which complicates the structure and adds cost. Also, it may increase the probabilty of failures since any misadjustement of this additional component increases the heat load in the fiber connection system.

The need for a reliable light-to-fiber interface for high power radiation applies generally to all laser/fiber applications, but is especially important in optical fiber communication systems which, e.g. in undersea long-distance and intercontinental communication networks, use repeatered submarine fiber cables. The laying and recovery of such fiber cables is very costly so that failures must be avoided as far as possible. In communication networks, lasers are often used for pumping erbium-doped fiber amplifiers, so-called EDFAs, which have been described in various patents and publications known to a person skilled in the art. There are three types of technically significant optical pumps typically used for erbium amplifiers, corresponding to the absorption wavelengths of erbium: strained quantum-well InGaAs lasers are used at 980nm; GaAlAs lasers at 820nm, and InGaAsP and multiquantum-well InGaAs lasers at 1480nm.

But, as explained above, the present invention is not limited to the use in optical fiber communication systems, but is applicable to all high power laser-to-fiber interfaces.

Optical fibers generally have a circular cross section, often with a core having a diameter of only a few µm, as mentioned above. It is obviously difficult to launch a 100W beam with the combined beam parameter product of several lasers into an "entry" with such small dimensions and a mismatch occurs easily. Significant efforts have been made to avoid the losses occurring by this mismatch, because finally the power coupled into the fiber - and not the "raw" power of the laser diode - determines the performance of a fiber network. But the issue addressed here is different: it is the danger arising from the stray radiation power, i.e. the power which is not properly coupled into the fiber core. This stray radiation endangers function and reliability of the laser module because it is transferred into heat.

Thus, it is the main and principal objective of the invention to provide a solution to the issues addressed above and to overcome the disadvantages and limitations of the described prior art designs. This is achieved by devising a laser module structure which provides an efficient and reliable dissipation of stray radiation power and the resulting heat, thus resulting in a high power laser module with stable output power, good performance and, at the same time, high reliability, applicable for single laser modules as well as for multi-emitter or multi-laser modules.

### Brief Description of the Invention

In brief, the novel high power laser module according to the invention achieves the above-named objectives by a structure which guarantees that all stray, i.e. non-effective, radiation emerging from the laser or laser arrangement is diverted away from the fiber, especially away from heat-sensitive components of the fiber, in particular the covering or coating of the fiber. This is done by an appropriate design of the components, in particular the ferrule, surrounding the fiber entry, by selecting the refractive indices of these components and their materials, and especially by integrating a deflector shielding the heat-sensitive parts of the fiber.

This deflector is not a separate part, but integrated as a coating on a component which is anyway provided in the structure, thus keeping cost down as well as simplifying manufacturing and avoiding misadjustments.

In particular, the invention discloses a ferrule which closely surrounds the cladding and core of the fiber and includes an integrated shielding means adapted for diverting the stray fraction of the high power laser radiation into the heat-dissipating part of the module. This integrated shielding means may be designed as a reflective coating, in particular a metal coating, especially a gold coating, on the ferrule's rear end opposite the laser.

It is advantageous to design the integrated shielding means as a cone or similar, funnel-shaped orifice at the rear end of the ferrule opposite the laser, whereby this orifice opens outwards. The outside diameter of this orifice is smaller than or equal to the outside diameter of the ferrule's rear end and the remaining outside doughnut or annulus of the ferrule's rear end is preferably arranged perpendicular to the ferrule's center axis. In particular may the outside doughnut also feature the above-mentioned reflective coating, especially the Au-coating.

The cladding of the fiber is fixed to the ferrule by an adhesive with a predetermined refractive index, whereby the fiber core has a first refractive index, the cladding has a second refractive index smaller than said first refractive index, the adhesive has a third refractive index and the ferrule has a fourth refractive index close to, but larger than said third refractive index, both said third and fourth refractive indices being larger than said second refractive index. With this arrangement of refractive indices, the light is directed efficiently towards the snout of the housing where it is absorbed either by the snout itself or an absorbing layer inside the latter. The generated heat is then removed via the housing wall.

Preferably, the first refractive index is selected between 1.42 and 1.52, the second refractive index between 1.40 and 1.50, the third refractive index between 1.42 and 1.7, and the fourth refractive index is selected between 1.45 and 1.8.

Specifically, the first refractive index is 1.4498, the second refractive index is 1.442, the third refractive index is 1.46, and the fourth refractive index is 1.49.

Furthermore, several additional layers of material with predetermined refractive indices may be arranged around the ferrule, preferably with increasing refractive indices towards the heat-dissipating component of said module.

Further features and advantages can be derived from the following description of embodiments of the invention and from the appended claims.

### Brief Description of the Drawings

Preferred embodiments of the invention are described below with reference to the drawings. The drawings are provided for illustrative purposes and are not necessarily to scale.
- Fig. 1: shows a complete longitudinal section through a first embodiment of the invention in a demo or lab arrangement;
- Fig. 2: illustrates details of a second embodiment;
- Fig. 3: depicts a third embodiment of the invention; and
- Fig. 4: shows a longitudinal section of another embodiment of the invention including the heat flow.

### Detailed Description of the Embodiments

In the following, the invention is described by means of several examples and embodiments showing features and characteristics of the invention. Single inventive features from this description and/or from the claims can be realized alone or with others in embodiments differing from the embodiments shown. Thus, the following description does not limit the scope and breadth of the present invention.

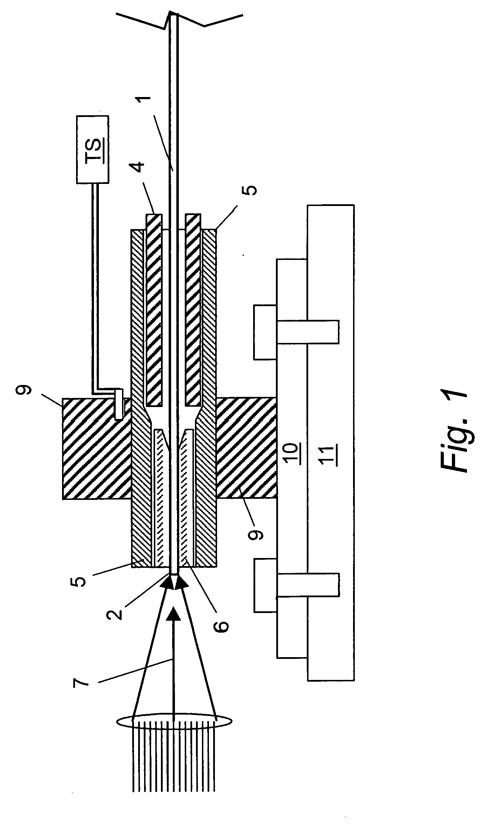

Fig. 1 shows a complete longitudinal section through a first embodiment of the invention in a demo or lab arrangement.

In the pigtail shown, the end of the fiber 1 is held in a back sleeve 4, usually made of a metal, and a transparent ferrule 6. In the back sleeve 4, the fiber still has its coating (not shown), whereas the latter is removed from the fiber 1 in the ferrule 6. The latter is made of a material which is transparent in the stray light wavelength range, usually a glass or a similar material.

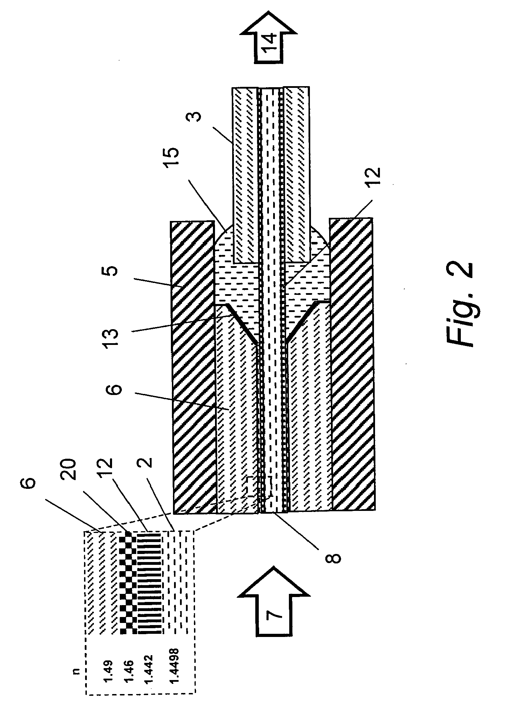

The inbound end of the "naked" fiber, i.e the fiber core 2 with its cladding (12 in Fig. 2), extends somewhat, say 0.5mm, towards the laser, but it may as well be in-line with the ferrule front side as shown in Fig. 2. Both the ferrule 6 and the back sleeve 4 are held in an outer sleeve or module snout 5 which, in Fig. 1, is shown fixed to a solid block 9, preferably of copper or a similar heat-conducting material.

In a real working environment, the fiber pigtail arrangement would usually be fixed to the wall of a module housing containing one or more lasers, resulting in a compact module with an electrical power input and a radiation output through the fiber.

In the lab arrangement shown in Fig. 1, the block 9 is fixed to a base plate 10 which in turn is located on a heat sink 11. A temperature sensor TS monitors the temperature of the block 9.

In this way, the fiber entry 8 is fixed relative to the laser (not shown) whose radiation 7 is focused onto the fiber core 2. Considering the small diameter of the fiber core 2, it is unavoidable that some of the radiation does not enter the core, but instead strays onto or into the transparent ferrule 6 or even onto the outer sleeve 5 shown in Fig. 1.

To prevent that the heat caused by the absorption of the stray light damages the fiber 1, the various components of the pigtail, especially those facing the impinging radiation, have selected properties which will be described and explained in the following.

Fig. 2 shows an arrangement according to the invention in more detail, focusing on the critical parts of the design, i.e. the parts providing the heat protection and transfer. Identical parts carry the same reference numbers as in Fig. 1.

As shown in Fig. 1, the end of the fiber is held in a ferrule 6, but there is no back sleeve. Outside the ferrule 6, the fiber still has its coating 3. The ferrule 6 is made of a transparent material, usually a glass or an optically similar material.

The inbound end of the "naked" fiber, i.e the fiber core 2 with its cladding 12 is in line with the ferrule front side. The ferrule 6 is held in an outer sleeve or snout 5 of a heat-conducting material.

The incoming or inbound radiation 7, here shown as an arrow, enters the fiber entry 8, but unavoidably also strays into the neighboring parts, i.e. essentially the ferrule 6 and the fiber cladding 12. As mentioned, the main object of the present invention is to control this stray energy and avoid any module failures based on this stray energy.

The outbound radiation 14, i.e. the radiation progressing within the fiber, is also shown as an arrow of somewhat smaller size, the decrease in size indicating the loss because of the stray radiation mentioned above.

Several inventive features assure that practically all stray radiation is either lead away from the fiber (and thus rendered harmless) or guided into the fiber (and thus made useful). The most significant features are:
1. radiation entering the cladding 12 is directed towards the ferrule 6, therein to the ferrule's outside circumference and from there transferred to a heat sink;
2. radiation entering the ferrule 6 is also directed towards the ferrule's outside circumference and from there transferred to a heat sink;
3. radiation reaching the inside end of the ferrule is reflected by a reflector 13 at the ferrule's inside end;
4. a thermal, i.e. heat-conducting, adhesive 15 for fixing the various parts assures heat transfer outside of the ferrule's orifice 13;
5. a transparent adhesive 20, preferably UV-curing, fixes the coating-stripped fiber inside the ferrule 6, which adhesive enables stray light from the cladding 12 to be transmitted into the ferrule 6; and
6. a specific selection of the refractive indices of the various parts and/or materials, especially of fiber core 2, fiber cladding 12, adhesive 20, and ferrule 6, assures that all dangerous stray radiation is directed to the ferrule's outside circumference and from there transferred to a heat sink where it is rendered harmless.

These features, at least partly combined, guarantee efficient removal of radiation not guided in the fiber core 2, in particular prevent any stray radiation from entering the fiber coating 3.

The enlargement in the left part of Fig. 2 shows the materials and their refractive indices at the fiber entry 8, i.e. the section where the focused inbound radiation impinges onto the fiber. It is apparent that the fiber cladding 12 has a refractive index of 1.442, which is, as usual, somewhat smaller than the refractive index of 1.4498 of the fiber core 2. The refractive index of the UV-curing and transparent adhesive 20 is 1.46, i.e. higher than the refractive index of both the fiber cladding 12 and the core 2. Even higher, namely 1.49, is the refractive index of the transparent ferrule 6. This selection of refractive indices, especially their numbers relative to each other, guarantees that any incoming stray radiation is hindered to develop dangerous effects.

Two further features foreclose any heating-up of the fiber coating 3, which, being often an acrylate, is particularly heat sensitive, having a flashpoint of ca. 200°C only. The first of these features concerns the transparent ferrule 6 whose inner end, i.e. the end opposite the laser, has the above-mentioned conical or funnel-shaped orifice which is coated with a radiation-reflecting material, thus forming reflector 13. The latter may be any high gloss metal, preferably Au. A reflecting non-metal may as well be used. Reflector 13 may either cover the funnel-shaped orifice of the ferrule 6 only or cover both the funnel-shaped part and the circular ring or doughnut around this funnel-shaped part.

Also, instead of using a separate coating for the reflector 13, the material filling the space between the ferrule 6 and the beginning of the fiber covering 3 may be employed for providing the desired reflection. H20E from EPO-TEK® is a suitable two-component, silver-filled epoxy system which may be used for this purpose.

In lieu of coating the funnel-shaped part of the transparent ferrule 6, a reflector may be provided based on total internal reflection by choosing the proper angle and difference of indices of reflexion between the ferrule 6 and any adjacent material. The latter material may be air or a gas, for example.

As indicated above, the ferrule's rear orifice may have the shape of a cone, wedge, pyramid, or similar funnel-shaped orifice. Anyway, this orifice is opening towards the rear end of the ferrule 6 and forms the reflector or integrated shielding means 13.

The second of these features is the thermal adhesive 15 which fills the space between the ferrule's inner end and the beginning of fiber coating 3 and thus not only holds the parts together but also reduces the temperature in this section of the pigtail. As mentioned above, this adhesive may also provide the reflector 13. H20E from EPO-TEK® is a suitable two-component, silver-filled epoxy system which was originally designed for chip bonding in microelectronic devices.

One specific point to be mentioned is that the area providing the heat transfer increases with the radius, i.e. the circumference or periphery of the transparent ferrule 6 provides for a better heat transfer the larger its diameter is.

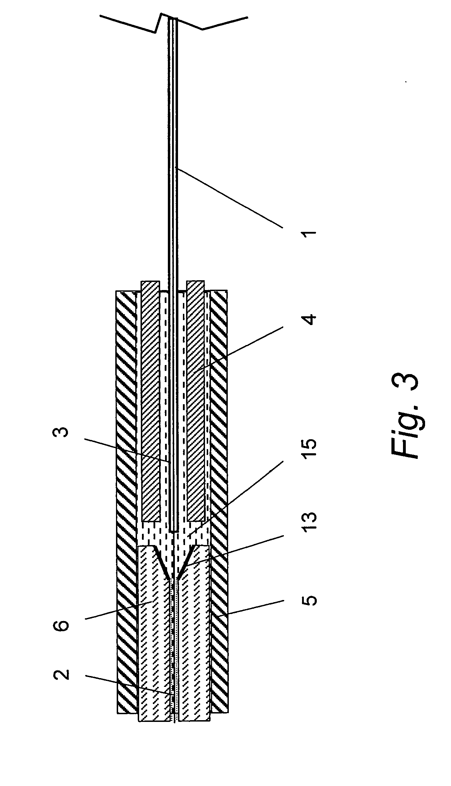

Fig. 3 shows another embodiment of the invention, including a glass ferrule 6 with its Au-coated reflector 13, a metal tube or back sleeve 4 holding the fiber 1, all packed into the outer sleeve or module snout 5 which is fixed to a module housing (not shown). Within the ferrule 6, the coating-stripped fiber is held by means of a glue or adhesive 20, preferably an UV-hardening glue. Behind the ferrule 6, i.e. between the fiber 1 and the back sleeve 4 and between the latter and the snout 5, a silver epoxy or soft solder 15, e.g. the above-mentioned H20E or an indium solder, fills the space.

An exemplary ferrule 6 as shown in Fig. 3 has a length of 6mm and an outside diameter of slightly less than 2.5mm. It is made from a transparent material such as borosilicate glass which is preferable. Zirkonium dioxide, ZrO₂, may also be used. The ferrule 6 has a cone or similar funnel-shaped orifice with a metal, especially Au, coating which serves as reflector 13, removing the radiation which is not guided in the fiber core. Alternatively a soft solder 15 filling the cone could act as a reflector 13.

An exemplary snout 5 has a length of 12mm with an inner diameter of 2.5mm and is made of Ni with an Au-coated outside surface to make it solderable. It is soldered into the housing (not shown) of the laser module. It mechanically fixes the ferrule 5 in the housing and provides a very good heat dissipation. Additionally, the snout 5 could be covered inside by an addional layer enhancing the absorption of the unwanted light or radiation.

An exemplary back sleeve 4 has a length of 6-8mm and an outside diameter of 2.0-2.2mm. It is made from Ni or Cu or another heat-conducting material with a properly chosen thermal expansion coefficient and serves to remove any residual heat remaining behind the ferrule 6. It also provides a homogeneous distribution of the silver epoxy 15 over the coating 3 of the fiber 1.

All the above parts are low-cost parts and well suited for mass production.

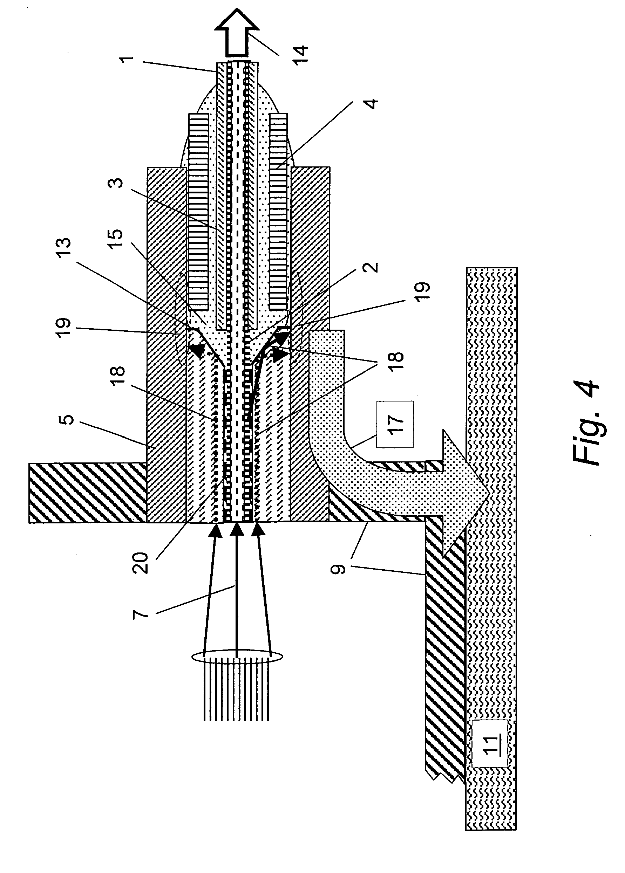

Fig. 4 finally shows the heat flow in a further embodiment. As before, identical parts carry the same reference numbers, so they do not need to be explained in detail here again.

A transparent ferrule 6 with its Au-coated conical or funnel-shaped reflector 13 and a back sleeve 4 hold the fiber 1. This is all packed into a snout 5 which is fixed to a block or package wall 9 which in turn is connected to a heat sink 11. A silver epoxy 15, e.g. the above-mentioned H20E, fills the space behind the ferrule 6, between the fiber 1 and the back sleeve 4, and between this back sleeve 4 and the snout 5.

The snout 5 as well as the package wall 9 may be made from a metal or a heat-conductive ceramic.

The stray radiation or uncoupled light 18 received by the ferrule 6, indicated by arrow 18, is reflected by reflector 13 towards the heat transfer or absorption area 19 and from there to the heat sink 11. Arrow 17 indicates this heat flow.

As indicated, the invention is not limited to the examples described above but can be varied within the scope of the following claims. Also, as will be understood by a person skilled in the art, this invention is applicable to a beam or beams of laser radiation originating from one or more individual lasers or a multi-emitter laser in a module.

## Claims

1. A high power laser module with a radiation-emitting laser, in particular a semiconductor laser, coupling high power laser radiation (7) into an optical fiber (1) for transmitting said emitted radiation, comprising
- a fiber (1) with a central core (2) for conducting said radiation, a cladding (12) around said core, and a covering (3) surrounding said cladding for mechanical support and/or protection of said fiber,
- a transparent ferrule (6) holding said fiber by clasping around it, said ferrule being inserted into a heat-dissipating component (5) of said module, **characterized by**
- said ferrule (6) closely surrounding cladding (12) and core (2) of said fiber (1) and being fixed to it by a transparent adhesive (20),
- said core (2), said cladding (12), said adhesive (20), and said ferrule (6) each having a predetermined refractive index, said indices being related to each other for directing any stray radiation into said heat-dissipating component (5) of said module, and
- said ferrule (6) including integrated shielding means (13) adapted for diverting and/or reflecting the stray fraction of said high power laser radiation (7) into said heat-dissipating component (5).

2. The laser module according to claim 1, wherein
the integrated shielding means (13) includes a reflective coating on the ferrule's (6) rear end opposite the laser.

3. The laser module according to claim 2, wherein
the reflective coating is a metal coating, in particular an Au coating.

4. The laser module according to claim 2, wherein
the reflective coating is a dielectric coating, in particular a multi-layer dielectric coating.

5. The laser module according to claim 1, including
a reflecting adhesive material (15) or a soft solder located adjacent the ferrule's (6) rear end, providing for the desired reflection at the ferrule's (6) rear end.

6. The laser module according to claim 1, wherein
total reflection at the ferrule's (6) rear end is provided by selecting the refractive index of the ferrule's (6) material, the form and the inclination of the ferrule's rear end, and the refractive index of the substance adjacent the ferrule's rear end.

7. The laser module according to any preceding claim, wherein
the ferrule's (6) rear end constitutes a funnel-shaped orifice which opens towards said rear end.

8. The laser module according to claim 7, wherein
the funnel of the orifice has the shape of a cone, a wedge, or a pyramid, any of them opening towards the rear end of the ferrule (6).

9. The laser module according to claim 7 or claim 8, wherein
the outside diameter of the orifice's funnel is equal to the outside diameter of the ferrule (6).

10. The laser module according to claim 7 or claim 8, wherein
- the outside diameter of the orifice's funnel is smaller than the outside diameter of the ferrule (6) and
- the remaining outside doughnut or annulus outside said funnel is arranged approximately perpendicular to the center axis of said ferrule (6).

11. The laser module according to claim 9 or claim 10, wherein
both the orifice's funnel and the remaining outside doughnut or annulus carry a reflective coating or provide total reflection.

12. The laser module according to any preceding claim, wherein
- the fiber core (2) has a first refractive index, the cladding (12) has a second refractive index smaller than said first refractive index,
- the adhesive (20) has a third refractive index, and
- the ferrule (6) has a fourth refractive index close to, but larger than said third refractive index,
- both said third and fourth refractive indices being larger than said second refractive index.

13. The laser module according to claim 12, wherein
- the first refractive index is between 1.42 and 1.52, in particular 1.4498,
- the second refractive index is between 1.40 and 1.50, in particular 1.442,
- the third refractive index is between 1.42 and 1.7, in particular 1.46, and
- the fourth refractive index is between 1.45 and 1.8, in particular 1.49.

14. The laser module according to any preceding claim, comprising one or several additional layers of material with predetermined refractive indices arranged around the ferrule (6), preferably with increasing refractive indices towards the heat-dissipating component (5) of said module.

15. The laser module according to any preceding claim, wherein
the heat-dissipating component (5) features a radiation-absorbing layer at its inside.

16. The laser module according to any preceding claim, comprising one or more laser diode(s) within a single module housing, said housing being connected to or integral with the heat-dissipating component (5) and serving as heat sink of said module.

17. The laser module according to any preceding claim, wherein
the ferrule (6) is made of or contains a borosilicate glass.
